Europäisches Patentamt

European Patent Office

Office européen des brevets

(19)

(11) Veröffentlichungsnummer : **0 421 460 B1**

## (12) EUROPÄISCHE PATENTSCHRIFT

(45) Veröffentlichungstag der Patentschrift :
**23.02.94 Patentblatt 94/08**

(51) Int. Cl.$^5$ : **H01S 3/103, H01S 3/25**

(21) Anmeldenummer : **90119154.4**

(22) Anmeldetag : **05.10.90**

(54) **Strahlungsquelle für teilkohärente Strahlung.**

(30) Priorität : **06.10.89 DE 3933443**

(43) Veröffentlichungstag der Anmeldung :
**10.04.91 Patentblatt 91/15**

(45) Bekanntmachung des Hinweises auf die
Patenterteilung :
**23.02.94 Patentblatt 94/08**

(84) Benannte Vertragsstaaten :
**CH DE FR GB LI NL**

(56) Entgegenhaltungen :
**US-A- 4 847 479**
**THE TRANSACTIONS OF THE IEICE, Band
E-70, Nr. 11, November 1987, Seiten
1065-1067; H. SHIMADE et al.: "Measurement
of coherence characteristics of semiconductor laser driven by high-frequency current injection"**

(56) Entgegenhaltungen :
**OPTICS LETTERS, Band 13, Nr. 8, August
1988, Seiten 628-630, Optical Society of America, New York, US; W.-K. CHEN et al.:
"Short-coherence-length and high-coupling-
-efficiency pulsed diode laser for fiber-optic
sensors"**
**PATENT ABSTRACTS OF JAPAN, Band 6, Nr.
226 (E-141)[1104], 11. November 1982; & JP-
A-57 128 089**

(73) Patentinhaber : **Firma Carl Zeiss**
**D-73446 Oberkochen (DE)**
(84) **CH DE FR LI NL**
Patentinhaber : **CARL ZEISS-STIFTUNG
HANDELND ALS CARL ZEISS
D-89518 Heidenheim (Brenz) (DE)**
(84) **GB**

(72) Erfinder : **Vry, Uwe, Dr.**
**Auchtwiesenstrasse 17**
**W-7080 Aalen (DE)**
Erfinder : **Freischlad, Klaus, Dr.**
**Brandweg 4**
**W-7080 Aalen (DE)**
Erfinder : **Küchel, Michael, Dr.**
**Keplerstrasse 3**
**W-7082 Oberkochen (DE)**
Erfinder : **Dorsel, Andreas, Dr.**
**Eulenweg 3**
**W-7080 Aalen (DE)**

**Beschreibung**

Die vorliegende Erfindung betrifft eine Strahlungsquelle für kohärente Strahlung bestehend aus einer Laserdiode und einer Versorgungseinheit, bei der die Wellenzahl k der emittierten Strahlung als Funktion der Zeit t in einem Bereich mit den Grenzwerten $k_{min}$ und $k_{max}$ moduliert ist.

Ein derartiger Betrieb einer Laserdiode ist aus einer Veröffentlichung von Shimade e.a. (Transactions of the IEICE <u>E70</u>, No. 11, (1987)) bekannt. Dort wird dem Injektionsstrom ein hochfrequenter sinusförmiger Strom überlagert, um die Kohärenzlänge der emittierten Strahlung zu verringern. Eine Verringerung der Kohärenzlänge ist bei zahlreichen Geräten, die auf Interferenz beruhen, vorteilhaft, weil dadurch das Signal-Rausch-Verhältnis verbessert wird. In der oben genannten Veröffentlichung wird der Strom moduliert, was unmittelbar eine Modulation der Wellenlänge bzw. Wellenzahl der emittierten Strahlung bewirkt und damit die Kohärenzlänge der Strahlung ändert. Da die Wellenlänge bzw. Wellenzahl auch über die Betriebstemperatur der Laserdiode verändert werden kann, ist es konsequenter, von der Modulation der Wellenzahl zu sprechen, weil der spektrale Verlauf der emittierten Strahlung unmittelbar die Kohärenzfunktion beeinflußt.

Für das Signal-Rausch-Verhältnis bestimmter interferometrischer Anordnungen ist nicht nur die Kohärenzlänge der benutzten Strahlung maßgebend, sondern die gesamte Kohärenzfunktion, d.h. der Kohärenzgrad als Funktion der optischen Wegdifferenz. Am günstigsten ist eine Kohärenzfunktion mit einem hohen Kohärenzgrad innerhalb der gewünschten Kohärenzlänge und einem möglichst steilen und vor allem stetigen Abfall außerhalb der Kohärenzlänge. Insbesondere sind Nebenmaxima des Kohärenzgrades außerhalb der Kohärenzlänge unerwünscht.

Ein Nachteil der aus der oben genannten Veröffentlichung bekannten sinusförmigen Modulation des Injektionsstromes ist, daß sowohl bei monomodigen als auch bei multimodigen Laserdioden außerhalb der gewünschten Kohärenzlänge zahlreiche Nebenmaxima auftreten. Bei multimodigen Dioden treten diese Nebenmaxima bei optischen Wegdifferenzen von Vielfachen der doppelten optischen Resonatorlänge auf. Bei monomodigen Dioden hängt die Lage der Nebenmaxima hauptsächlich von der Modulationsamplitude ab.

Der vorliegenden Erfindung liegt daher die Aufgabe zugrunde, eine Strahlungsquelle zu schaffen, deren Strahlung eine vorgegebene Kohärenzlänge hat und deren Kohärenzfunktion außerhalb der Kohärenzlänge auf beiden Seiten ohne Nebenmaxima möglichst steil und stetig abfällt. Der Erfindung liegt ferner die Aufgabe zugrunde, eine Strahlungsquelle mit sehr kurzer Kohärenzlänge und einer Kohärenzfunktion ohne Nebenmaxima zu schaffen.

Die gestellte Aufgabe wird einerseits ausgehend von einer Strahlungsquelle nach dem Oberbegriff des Anspruches 1 erfindungsgemäß dadurch gelöst, daß für die Modulationsfunktion mindestens eine der folgenden Bedingungen erfüllt ist

wenn $k > k_{min}+3(k_{max}-k_{min})/4$, dann ist $d^2k/dt^2 > 0$,

wenn $k < k_{min}+ (k_{max}-k_{min})/4$, dann ist $d^2k/dt^2 < 0$.

Die gestellte Aufgabe wird andererseits erfindungsgemäß, dadurch gelöst, daß die Strahlungen von mindestens zwei monomodigen Laserdioden räumlich kongruent zusammengeführt sind, daß die Wellenzahlen k der emittierten Strahlungen abhängig von der Zeit t mit Modulationsfunktionen in Wellenzahlbereichen, die aneinander anschließen oder überlappen, moduliert sind und daß für die Modulationsfunktion einer Laserdiode mit den Grenzwerten $k_{min}$ und $k_{max}$ mindestens eine der folgenden Bedingungen erfüllt ist

wenn $k > k_{min}+3(k_{max}-k_{min})/4$, dann ist $d^2k//dt^2 > 0$,

wenn $k < k_{min}+ (k_{max}-k_{min})/4$, dann ist $d^2k/dt^2 < 0$.

Besonders vorteilhaft ist es, die gewünschte Modulationsfunktion der Wellenzahl durch eine Modulation des Injektionsstromes für die Laserdiode(n) zu erreichen. Dazu ist es nur notwendig, aus den Kennlinien der Laserdiode(n) Wellenzahl als Funktion des Injektionsstromes und Leistung als Funktion des Injektionsstromes (bei konstanter Betriebstemperatur) für die ermittelte Modulationsfunktion der Wellenzahl die notwendige Modulationsfunktion des Injektionsstromes zu berechnen.

Es ist jedoch auch möglich, die Betriebstemperatur der Laserdiode(n) zu modulieren. In diesem Fall wird aus den Kennlinien der Laserdiode(n) Wellenzahl als Funktion der Betriebstemperatur und Leistung als Funktion der Betriebstemperatur (bei konstantem Injektionsstrom) die Modulationsfunktion der Betriebstemperatur berechnet. In diesem Fall muß die Laserdiode eine möglichst geringe Wärmekapazität haben, was insbesondere dann der Fall ist, wenn die Temperatur der Strahlung emittierenden Schicht direkt geregelt werden kann.

Auch eine Kombination von Modulation des Injektionsstromes und Modulation der Betriebstemperatur ist möglich.

Die Modulation kann grundsätzlich auch durch jeden anderen Betriebsparameter, der die Wellenzahl ändert, erfolgen. So ist z.B. auch eine Modulation über den Druck, der auf die Laserdiode ausgeübt wird, möglich. Ferner kann die Modulation auch bei konstanten Betriebsparametern der Laserdiode durch eine externe Änderung der Wellenzahl erfolgen, z.B. durch Phasenmodulation mit einer Pockelszelle.

EP 0 421 460 B1

Die Modulation kann einmal, mehrmals oder periodisch erfolgen.

Es ist notwendig, die Laserdiode(n) im sog. modensprungfreien Bereich zu betreiben, da sonst Nebenmaxima in der Kohärenzfunktion auftreten.

Die die Kennlinien von Laserdioden, wie z.B. Wellenzahl als Funktion des Injektionsstromes, von Exemplar zu Exemplar Unterschiede zeigen, ist es bei hohen Anforderungen an die Kohärenzfunktion der emittierten Strahlung zweckmäßig, für jedes Exemplar eine individuelle Modulationsfunktion zu ermitteln. Hierfür ermittelt man einmal aus der gewünschten Kohärenzfunktion über Fouriertransformation die dazu gehörende Spektralfunktion. Anschließend wird aus der Spektralfunktion für jede Laserdiode aus den für sie geltenden Kennlinien die zugehörige Modulationsfunktion ermittelt.

Weitere vorteilhafte Ausgestaltungen der Erfindung gehen aus den Unteransprüchen und den Erläutertungen zu den Figuren hervor.

Die Erfindung wird im folgenden anhand von in den Figuren 1 bis 12 dargestellten Ausführungsbeispielen erläutert. Dabei zeigen:

Fig. 1       eine vorteilhafte Kohärenzfunktion;
Fig. 2       die dazu gehörende Spektralfunktion;
Fig. 3       eine Laserdiodenkennlinie Leistung als Funktion des Injektionsstromes;
Fig. 4       eine Laserdiodenkennlinie Wellenzahl als Funktion des Injektionsstromes;
Fig. 5       die aus den Kennlinien in Fig. 3 und 4 ermittelte Kennlinie Leistung als Funktion der Wellenzahl;
Fig. 6       zwei Modulationsfunktionen;
Fig. 7       mögliche Kombinationen aus den Modulationsfunktionen in Fig. 6;
Fig. 8       die Aufteilung einer Spektralfunktion in Modulationsbereiche für drei Dioden;
Fig. 9       die Modulationsfunktionen für die drei Dioden;
Fig. 10      eine mögliche Kombination der Modulationsfunktionen für jede der drei Dioden und ihre Beziehungen zueinander;
Fig. 11      ein Blockschaltbild für die Realisierung einer Modulationsfunktion und
Fig. 12      ein Blockschaltbild für eine andere Realisierung einer Modulationsfunktion.

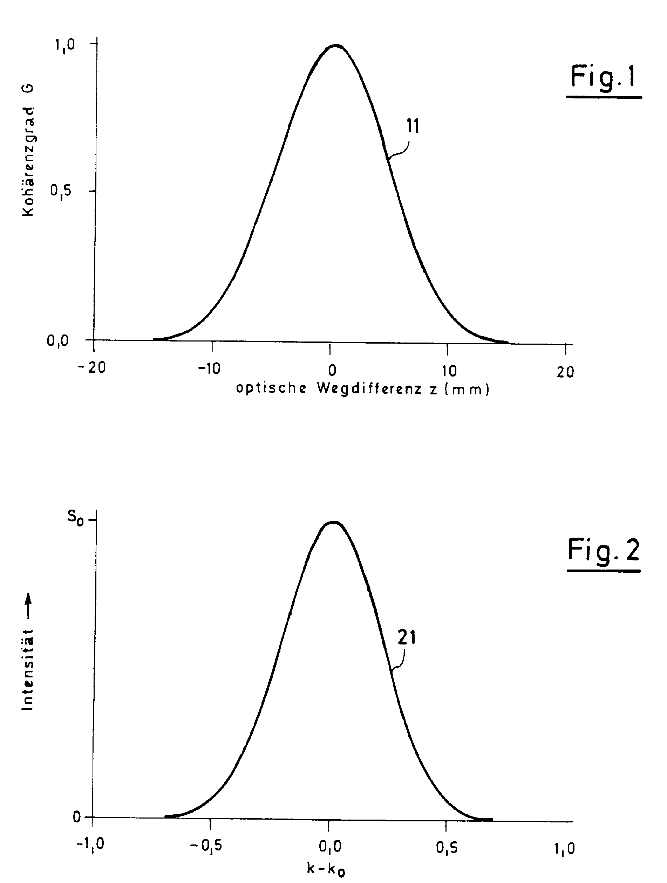

Es ist zweckmäßig, als Kohärenzfunktion eine Funktion zu verwenden, auf die sich die Fouriertransformation einfach anwenden läßt. Das ist z.B. bei einer Gaußschen Kohärenzfunktion der Fall, wie sie in Figur 1 dargestellt und mit (11) bezeichnet ist. Dort ist der Kohärenzgrad als Funktion der optischen Wegdifferenz z aufgetragen. Die Gaußsche Kohärenzfunktion ist gegeben durch

$$\left| G(z) \right| = \exp\left( - \frac{c^2 z^2}{4} \right), \quad (1)$$

dabei ist c eine Konstante, welche die Breite der glockenförmigen Gaußfunktion bestimmt.

Die zugehörige Spektralfunktion (Intensität als Funktion der Wellenzahl)

$$S(k) = s_o \exp\left( - \frac{(k - k_o)^2}{c^2} \right). \quad (2)$$

ist in Figur 2 dargestellt und mit (21) bezeichnet. Bei ihr ist k die Wellenzahl, $k_o$ die Wellenzahl des Maximums der Spektralfunktion und $s_o$ der Maximalwert der Spektralfunktion.

Die Realisierung einer derartigen Spektralfunktion wird anhand der folgenden Ausführungen erläutert.

Fällt auf einen Detektor eine Strahlung mit Strahlungsleistung P, so hat er nach der Meßzeit $\Delta t$ die Energie

$$W = P \cdot \Delta t \quad (3)$$

aufgenommen. Ändert sich während der Meßzeit die Wellenzahl der Strahlung in mehreren Schritten, dann fällt für jeweils eine Zeit von $\Delta t(k)$ eine Strahlung mit der Leistung P(k) und der Wellenzahl k auf den Detektor. Die gemessene Energie beträgt dann

$$W = \sum_k P(k) \cdot \Delta t(k) \quad . \quad (4)$$

Bei Verallgemeinerung auf ein kontinuierliches Durchstimmen (Modulation) der Wellenlänge ergibt sich

$$W = \int P(k) \cdot \left| \frac{dt}{dk} \right| dk = \int S(k)\, dk \quad . \quad (5)$$

Dabei wurde die Spektralfunktion

$$S(k) = P(k) / \left| \frac{dk}{dt} \right| \quad (6)$$

eingeführt. $\left| dk/dt \right|$ gibt die Geschwindigkeit an, mit der die Wellenzahl k durchgefahren wird.

Die Spektralfunktion gibt das (effective) Spektrum an, das mit der Laserdiode erzeugt wird. Die (zeitliche) Kohärenzfunktion, d.h. der normierte Kohärenzgrad $\left| G(z) \right|$ der Laserdiode mit dem effektiven Spektrum S(k)

3

als Funktion der optischen Wegdifferenz z, ist in bekannter Weise gegeben durch den Fourierzusammenhang

$$|G(z)| = \left| \frac{\int S(k) \exp(ikz)\, dk}{\int S(k)\, dk} \right| . \quad (7)$$

Im folgenden wird zunächst auf den Fall eingegangen, daß nur eine Laserdiode als Lichtquelle benutzt wird. In diesem Fall muß die Spektralfunktion nach Gleichung (2) durch eine Modulation der Wellenzahl dieser Diode nach Gleichung (6) die die Abhängigkeit der Ausgangsleistung der Laserdiode von der Wellenzahl berücksichtigt, erzeugt werden. Zur Bestimmung der Modulationsfunktion k(t) wird Gleichung (6) umgestellt:

$$\frac{dk}{dt} = \pm \frac{P(k)}{S(k)} . \quad (8)$$

Das Vorzeichen richtet sich danach, in welcher Richtung das Durchstimmen der Wellenzahl erfolgen soll.

In Gleichung (8) muß die gewünschte Spektralfunktion S(k) eingesetzt werden. Zusätzlich wird die Ausgangsleistung der Diode als Funktion der Wellenzahl benötigt, deren praktische Bestimmung im folgenden anhand eines Beispiels dargestellt wird.

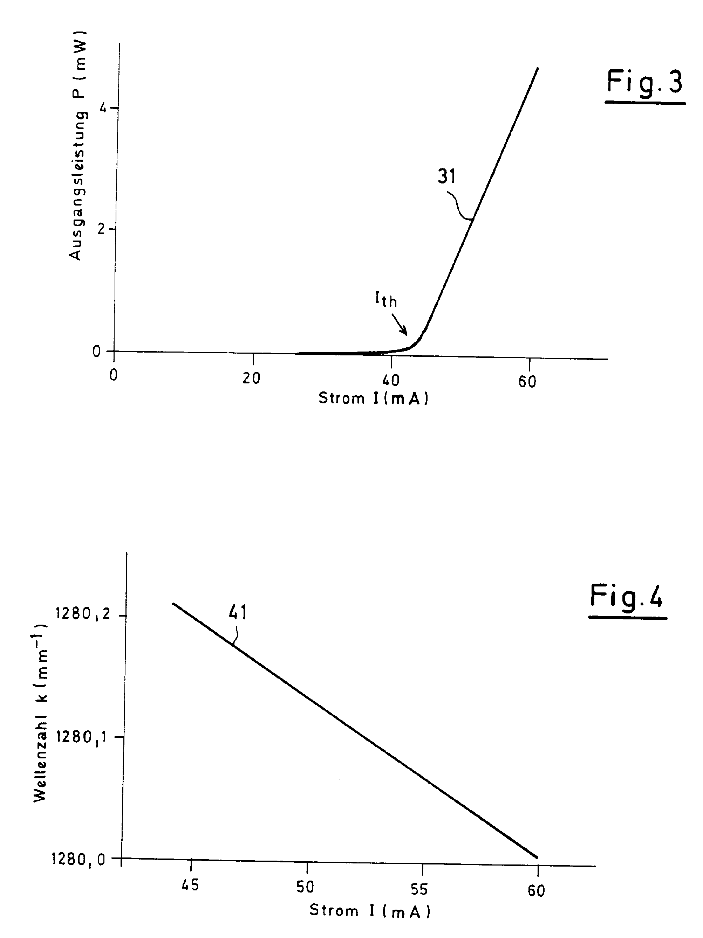

Figur 3 zeigt eine typische Leistungskennlinie (31) einer Laserdiode (Ausgangsleistung P als Funktion des Injektionsstromes I) bei fester Betriebstemperatur. Der Verlauf ist im allgemeinen oberhalb des Schwellstromes $I_{th}$, bei dem die Lasertätigkeit einsetzt, linear.

Figur 4 zeigt die Kennlinie (41) für die Abhängigkeit der Wellenzahl der emittierten Strahlung vom Injektionsstrom. Die konstante Betriebstemperatur ist dabei so gewählt, daß im gesamten Strombereich kein Modensprung auftritt.

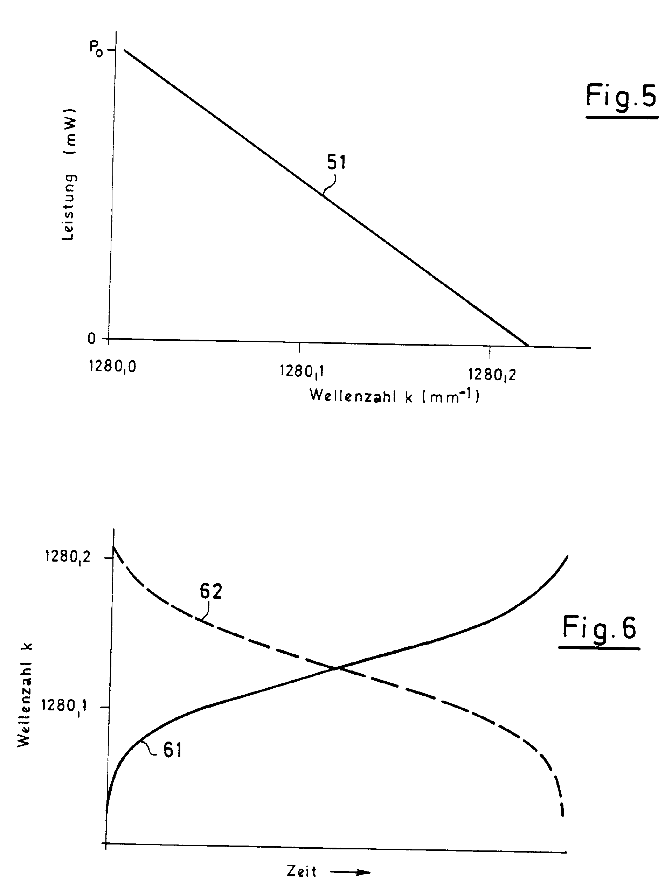

In Figur 5 sind die Figuren 3 und 4 zu einer Leistungskennlinie P(k) (51) zusammengefaßt, die den Zusammenhang zwischen Leistung und Wellenzahl beschreibt. Sie läßt sich in diesem Beispiel als Dreiecksfunktion beschreiben:

$$P(k) = \begin{cases} \dfrac{P_o}{2}\,(k_o - k + \triangle k)/\triangle k & \text{für } |k - k_o| < \triangle k \\[3mm] 0 & \text{sonst .} \end{cases} \quad (9)$$

Dabei ist an der Laserschwelle bei $k_o + \triangle k$ die Ausgangsleistung 0, während sie bei $k_o - \triangle k$ den Wert 1 hat. $\triangle k$ ist die halbe Breite des Wellenzahlbereichs, der mit der Laserdiode abgedeckt werden kann; $k_o$ ist die mittlere Wellenzahl dieses Bereichs.

In Figur 6 bezeichnet (61) einen typischen Verlauf einer Modulationsfunktion k(t), der sich als Lösung von Gleichung (8) mit Gleichung (2) und (9) für den Fall ergibt, daß eine einzelne Laserdiode als Lichtquelle benutzt und in Gleichung (8) das positive Vorzeichen gewählt wird. Aus dem in Figur 5 dargestellten Zusammenhang zwischen Wellenzahl und Strom kann direkt die zugehörige Modulationsfunktion I(t) bestimmt werden.

Wählt man in Gleichung (8) das negative Vorzeichen, so erhält man die mit (62) bezeichnete Modulationsfunktion k(t). Sie unterscheidet sich von der Funktion (61) lediglich durch die Richtung der Zeitachse.

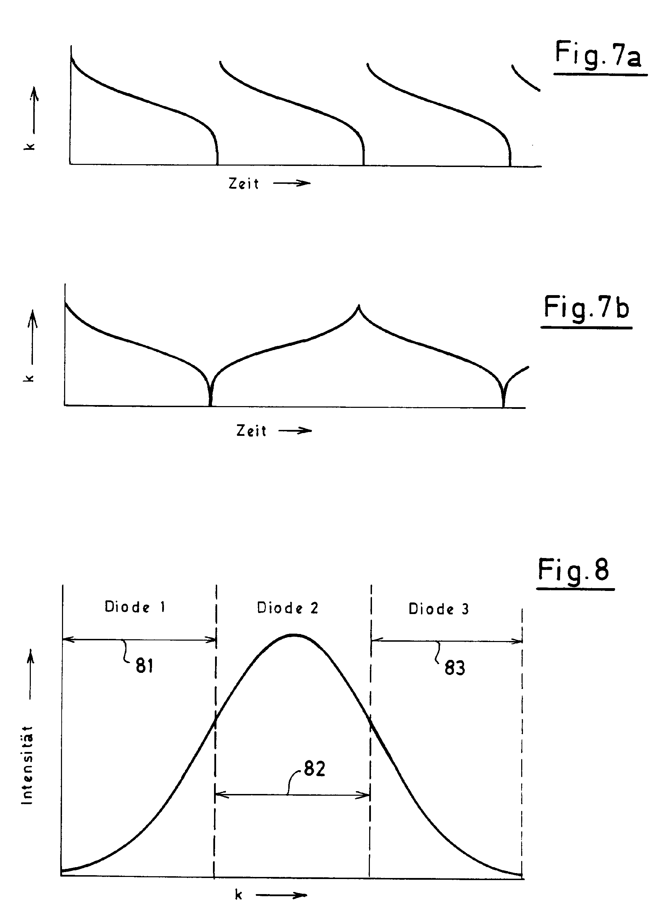

Aus den beiden Funktionen der Figur 6 können nun in vielfältiger Weise Modulationsfunktionen zusammengesetzt werden. In Figur 7 sind zwei mögliche Beispiele dargestellt.

Möchte man eine Kohärenzfunktion erzielen, die keine Nebenmaxima enthält, so ist ein Abfall der Spektralfunktion S(k) zum Rande des von der Diode abdeckbaren Wellenzahlbereichs $k_o \pm \triangle k$ erforderlich. Dies ergibt sich aus Gleichung (7) und den bekannten Eigenschaften der Fouriertransformation. Da im dargestellten Ausführungsbeispiel die Ausgangsleistung linear mit der Wellenzahl fällt, gilt im Bereich hoher Ausgangsleistung (im dargestellten Ausführungsbeispiel ist das der Bereich kleiner Wellenzahlen mit $k < k_o - \triangle k$ )

$$\frac{dS}{dk} > 0, \frac{dP}{dk} < 0 . \quad (10)$$

Durch zeitliche Differentiation von Gleichung (8), Anwendung der Ketten- und Produktregel und anschließendes Wiedereinsetzen von Gleichung (8) folgt für beliebiges Vorzeichen in Gleichung (8):

$$\frac{d^2k}{dt^2} < 0 \text{ für } k < k_o . \quad (11)$$

Steigt anders als im dargestellten Ausführungsbeispiel die Ausgangsleistung mit der Wellenzahl der Laserdiode, so gilt statt Gleichung (10) für $k > k_o + \triangle k$

$$\frac{dS}{dk} < 0, \frac{dP}{dk} > 0 . \quad (12)$$

4

In diesem Fall gilt

$$\frac{d^2k}{dt^2} > 0 \text{ für } k > k_o . \quad (13)$$

Eine dieser Bedingungen muß also erfüllt sein, wenn die Kohärenzfunktion keine Nebenmaxima haben darf. Sie werden von der von Shimade benutzten sinusförmigen Modulation nicht erfüllt, weshalb die derartig erzeugte Kohärenzfunktion Nebenmaxima haben muß. Auch andere bekannte Modulationsfunktionen, z.B. dreieck-, sägezahn- oder rechteckförmige Funktionen, erfüllen dieses Kriterium nicht.

Wenn man eine Kohärenzfunktion mit sehr geringer Breite, d.h. eine sehr kurze Kohärenzlänge, erzeugen will, dann benötigt man eine sehr große Breite der Spektralfunktion. Da der spektrale Bereich, der mit einer einzelnen Laserdiode modensprungfrei abdeckbar ist, begrenzt ist, ist es für sehr kurze Kohärenzlängen vorteilhaft, mehrere Laserdioden, deren spektrale Bereiche aneinander anschließen oder überlappen, gleichzeitig in einen Strahlengang einzukoppeln, d.h. räumlich zu überlagern.

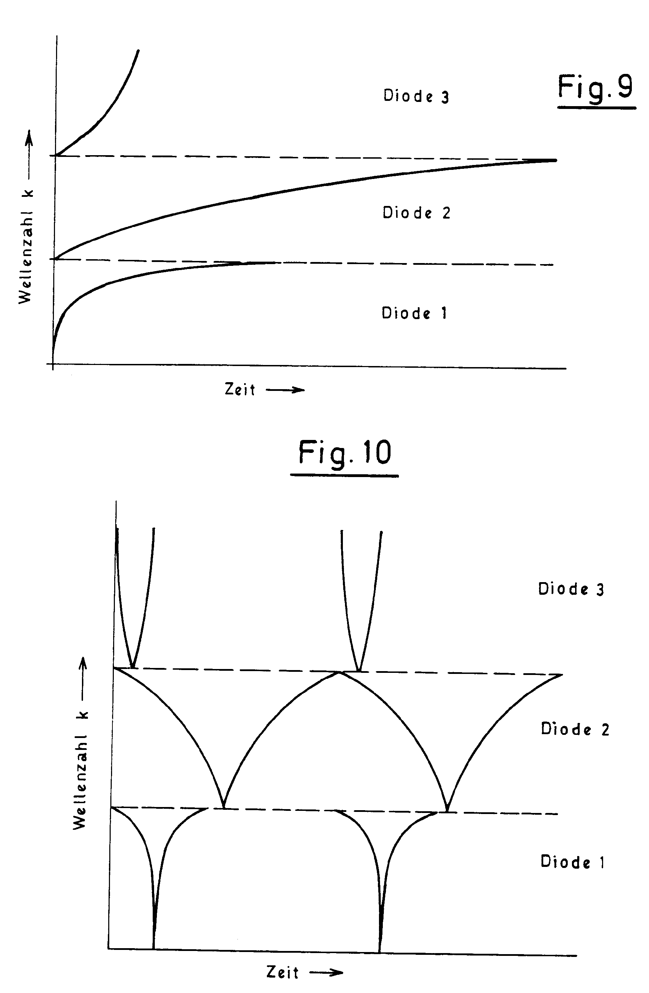

Als Ausführungsbeispiel werden im folgenden drei Dioden verwendet, die mit 1, 2 und 3 bezeichnet sind. In Figur 8 ist dargestellt, daß jede Diode einen Teil der Spektralfunktion übernimmt, d.h. daß ihre Strahlung in einem der Bereiche (81, 82, 83) moduliert wird. Es ist jedoch auch möglich, daß jede Diode einen bestimmten Anteil der Spektralfunktion übernimmt, wobei sich ihre Bereiche überlappen. Für jede Diode ist nun eine eigene Modulationsfunktion erforderlich, die nach Gleichung (8) separat für jede Diode unter Berücksichtigung des von ihr abzudeckenden Teiles bzw. Anteiles der Spektralfunktion berechnet wird. Figur 9 zeigt diese Modulationsfunktionen für positives Vorzeichen in Gleichung (8) und für Leistungskennlinien bei denen dP/dk < 0 ist.

Die oben bei Verwendung nur einer Diode gemachte Feststellung, daß, falls dP/dk < 0, im Bereich hoher Ausgangsleistung $d^2k/dt^2 < 0$ sein muß, läßt sich hier direkt auf die Diode 1 übertragen, die den Anteil der Spektralfunktion mit den kleinsten Wellenzahlen übernimmt. Ist dP/dk > 0, so gilt die oben für diesen Fall angestellte Überlegung für die Diode 3 mit den größten Wellenzahlen.

Figur 10 zeigt mögliche Kombinationen der drei Modulationsfunktionen und ihre Beziehungen zueinander für einen praktischen Betriebsfall. Dabei ist die Zeitachse gegenüber der Figur 9 ungefähr um den Faktor 5 verkürzt. Außerdem wurde davon ausgegangen, daß die Überlagerungen der drei Strahlungen der Dioden so geschieht, daß die durch die optischen Elemente zur Überlagerung der Strahlungen bewirkten Abschwächungen für alle Dioden gleich sind. Da das Durchfahren der Modulation z.B. bei Diode 1 kürzer dauert als bei Diode 2 muß Diode 1 eine entsprechende Zeit abgeschaltet sein. Will man auf das frühere Abschalten verzichten und stattdessen bei Diode 1 die Zeitskala um einen bestimmten Faktor "strecken", so muß man diese Diode um gleichen Faktor gegenüber den anderen Dioden abschwächen. Das gleiche gilt für die Diode 3.

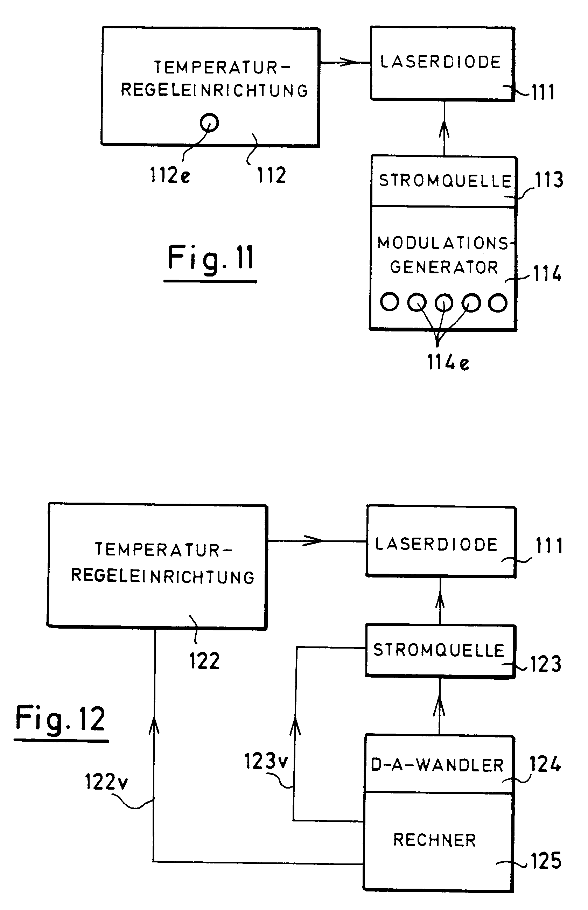

Figur 11 zeigt als Ausführungsbeispiel für die technische Realisierung ein Blockschaltbild für die Versorgung einer Laserdiode mit moduliertem Injektionsstrom. Die mit (111) bezeichnete Laserdiode wird auf einer konstanten Temperatur gehalten von der Temperatur-Regeleinrichtung (112). Diese kann in bekannter Weise aus einem Temperaturfühler, einem Peltierelement und einem Regler bestehen. An dem Einstellelement (112e) wird diejenige Temperatur eingestellt, die der Modulationsfunktion zugrunde liegt. Die Laserdiode (111) enthält ihren Injektionsstrom von der Stromquelle (113), an die ein Modulationsgenerator (114) angeschlossen ist. An seinen Einstellelementen (114e) werden für die Modulationsfunktion I(t) entweder unmittelbar ihre Werte oder ihre Parameter eingestellt.

In Figur 12 ist ein anderes Ausführungsbeispiel für die modulierte Stromversorgung dargestellt. Hier sind die Werte für die Modulationsfunktion I(t) in einem Rechner (125) bzw. Mikroprozessor gespeichert. Von diesem Rechner wird die erforderliche Temperatur der Laserdiode über die Verbindung (122v) an die Temperatur-Regeleinrichtung (122) übertragen, welche die Laserdiode auf diese Temperatur regelt. Vom Rechner (125) wird über den Digital-Analog-Wandler (124) die Modulationsfunktion I(t) an die Stromquelle (123) übertragen. Letztere erhält außerdem über die Verbindung (123v) den Wert für den konstanten Anteil des der Laserdiode zugeführten modulierten Injektionsstromes.

Wenn mehrere Laserdioden gleichzeitig verwendet werden, um eine sehr kurze Kohärenzlänge zu erreichen, dann ist für jede Laserdiode eine eigene Stromversorgung notwendig. Lediglich der Rechner bzw. Mikroprozessor ist nur einmal erforderlich, an ihn ist für jede Laserdiode eine Temperatur-Regeleinrichtung und eine modulierbare Stromquelle angeschlossen.

## Patentansprüche

1. Strahlungsquelle für teilkohärente Strahlung bestehend aus einer monomodigen Laserdiode (111) und einer Versorgungseinheit (Fig. 11), bei der die Wellenzahl k der emittierten Strahlung abhängig von der Zeit t mit einer Modulationsfunktion in einem Bereich mit den Grenzwerten $k_{min}$ und $k_{max}$ moduliert ist, dadurch gekennzeichnet, daß für die Modulationsfunktion (61, 62) mindestens eine der folgenden Bedingungen erfüllt ist

wenn $k > k_{min}+3(k_{max}-k_{min})/4$, dann ist $d^2k/dt^2 > 0$,

wenn $k < k_{min}+ (k_{max}-k_{min})/4$, dann ist $d^2k/dt^2 < 0$.

2. Strahlungsquelle für teilkohärente Strahlung mit einer Versorgungseinheit, dadurch gekennzeichnet, daß die Strahlungen von mindestens zwei monomodigen Laserdioden räumlich kongruent zusammengeführt sind, daß die Wellenzahlen k der emittierten Strahlungen abhängig von der Zeit t mit Modulationsfunktionen in Wellenzahlbereichen (81, 82, 83), die aneinander anschließen oder überlappen, moduliert sind und daß für die Modulationsfunktion einer Laserdiode mit den Grenzwerten $k_{min}$ und $k_{max}$ mindestens eine der folgenden Bedingungen erfüllt ist

wenn $k > k_{min}+3(k_{max}-k_{min})/4$, dann ist $d^2k/dt^2 > 0$,

wenn $k < k_{min}+ (k_{max}-k_{min})/4$, dann ist $d^2k/dt^2 < 0$.

3. Strahlungsquelle nach Anspruch 1 oder Anspruch 2, dadurch gekennzeichnet, daß die Wellenzahl k durch den Injektionsstrom der Laserdiode(n) moduliert ist.

4. Strahlungsquelle nach Anspruch 1 oder Anspruch 2, dadurch gekennzeichnet, daß die Wellenzahl k durch die Betriebstemperatur der Laserdiode(n) moduliert ist.

5. Strahlungsquelle nach Anspruch 1 oder 2, dadurch gekennzeichnet, daß die Wellenzahl k durch den Injektionsstrom und die Betriebstemperatur der Laserdiode(n) moduliert ist.

6. Strahlungsquelle nach einem der Ansprüche 1 bis 5, dadurch gekennzeichnet, daß in der Versorgungseinheit Mittel (114e) vorgesehen sind, mit denen für ein individuelles Exemplar einer Laserdiode eine individuelle Modulationsfunktion eingebbar ist.

7. Strahlungsquelle nach Anspruch 6, dadurch gekennzeichnet, daß für die Modulationsfunktion ein Modulationsgenerator (114) mit Einstellelementen (114e) für Werte der Modulationsfunktion vorgesehen ist.

8. Strahlungsquelle nach Anspruch 6, dadurch gekennzeichnet, daß für die Modulationsfunktion ein Modulationsgenerator (114) mit Einstellelementen (114e) für Parameter der Modulationsfunktion vorgesehen ist.

9. Strahlungsquelle nach Anspruch 6, dadurch gekennzeichnet, daß die Modulationsfunktion in einem Rechner (125) oder Mikroprozessor gespeichert ist, der über einen Digital-Analog-Wandler (124) mit der Stromquelle (123) der Versorgungseinheit verbunden ist.

10. Verfahren zur Ermittlung der Modulationsfunktion für eine Strahlungsquelle nach einem der Ansprüche 1 bis 9, dadurch gekennzeichnet, daß aus der gewünschten Kohärenzfunktion (11) über Fouriertransformation die dafür erforderliche Spektralfunktion (21) ermittelt, wird und daß aus der Spektralfunktion (21) und den Kennlinien der Laserdiode Wellenzahl als Funktion des Injektionsstromes (31) und Leistung als Funktion des Injektionsstromes (41) die Modulationsfunktion (61, 62) ermittelt wird.

## Claims

1. Radiation source for partially coherent radiation comprising a mono-mode laser diode (111) and a supply unit (Fig. 11), by which the wave number of the emitted radiation is modulated in dependence on the time t according to a modulation function within a value range having boundary values $k_{min}$ and $k_{max}$, characterized by the fact that the modulation function (61, 62) fulfils at least one of the following conditions:

   if $k > k_{min} + 3(k_{max}-k_{min})/4$, then $d^2 k/dt^2 > 0$;

   if $k < k_{min} + (k_{max} - k_{min})/4$, then $d^2 k/dt^2 < 0$.

2. Radiation source for partially coherent radiation comprising a supply unit, characterized by the fact that the radiations of at least two mono-mode laser diodes is spatially brought together congruently, that the wave numbers k of the emitted radiations are modulated in dependence on the time t according to modulation functions within wave number ranges (81, 82, 83) which are disposed one next to the other or in overlapping relationship to each other and that the modulation function with the boundary values $k_{min}$ and $K_{max}$ of one laser diode fulfils at least one of the following conditions:

if k > $k_{min}$ + 3($k_{max}$ - $k_{min}$)/4, then $d^2k/dt^2$ > 0;
if k < $k_{min}$ + ($k_{max}$ - $k_{min}$)/4, then $d^2k/dt^2$ < 0.

3. Radiation source according to claim 1 or claim 2 characterized by the fact that the wave number k is modulated via the injection current of the laser diode(s).

4. Radiation source according to claim 1 or claim 2, characterized by the fact that the wave number k is modulated via the operating temperature of the laser diode(s).

5. Radiation source according to claim 1 or 2, characterized by the fact that wave number k is modulated via the injection current and the operating temperature of the laser diode(s).

6. Radiation source according to one of the claims 1 to 5, characterized by the fact that means (114e) are provided in the supply unit for inputting an individual modulation function for an individual specimen of a laser diode.

7. Radiation source according to claim 6, characterized by the fact that a modulation generator (114) having adjusting elements (114e) for adjusting values of the modulation function is provided for the modulation function.

8. Radiation source according to claim 6, characterized by the fact that a modulation generator (114) having adjusting elements (114e) for adjusting parameters of the modulation function is provided for the modulation function.

9. Radiation source according to claim 6, characterized by the fact that the modulation function is stored in a computer (125) or a micro-processor which is connected to the current source (123) of the supply unit via a digital to analog converter (124).

10. Method for determining the modulation function for radiation source according to one of the claims 1 to 9, characterized by the fact that the necessary spectral function (21) is determined via Fourier transformation from the desired coherence function (11) and that the modulation function (61, 62) is determined from the spectral function (21) and the characteristic functions of the laser diode - wave number as function of the injection current (31) and power as function of the injection current (41).

## Revendications

1. Source de rayonnement pour un rayonnement partiellement cohérent, constituée d'une diode laser monomodale (111) et d'une unité d'alimentation (figure 11), selon laquelle le nombre d'ondes k du rayonnement émis est modulé en fonction du temps t, par une fonction de modulation, dans une plage présentant les valeurs limites $k_{min}$ et $k_{max}$, **caractérisée** en ce que la fonction de modulation (61, 62) remplit au moins une des conditions suivantes :
si k > $k_{min}$ + 3($k_{max}$ - $k_{min}$)/4, alors $d^2k/dt^2$ > 0,
si k < $k_{min}$ + ($k_{max}$ - $k_{min}$)/4, alors $d^2k/dt^2$ < 0.

2. Source de rayonnement pour un rayonnement partiellement cohérent, avec une unité d'alimentation, **caractérisée** en ce que les rayonnements d'au moins deux diodes laser monomodales sont réunis de façon spatialement congruente, en ce que les nombres d'ondes k des rayonnements émis sont modulés en fonction du temps t, par des fonctions de modulation, dans des plages de nombre d'ondes (81, 82, 83) qui se raccordent les unes aux autres ou se chevauchent, et en ce que la fonction de modulation d'une diode laser présentant les valeurs limites $k_{min}$ et $k_{max}$ remplit au moins une des conditions suivantes :
si k > $k_{min}$ + 3($k_{max}$ - $k_{min}$)/4, alors $d^2k/dt^2$ > 0,
si k < $k_{min}$ + ($k_{max}$ - $k_{min}$)/4, alors $d^2k/dt^2$ < 0.

3. Source de rayonnement selon la revendication 1 ou 2, **caractérisée** en ce que le nombre d'ondes k est modulé par le courant d'injection de la ou les diodes laser.

4. Source de rayonnement selon la revendication 1 ou 2, **caractérisée** en ce que le nombre d'ondes k est modulé par la température d'exploitation de la ou les diodes laser.

5. Source de rayonnement selon la revendication 1 ou 2, **caractérisée** en ce que le nombre d'ondes k est modulé par le courant d'injection et la température d'exploitation de la ou les diodes laser.

6. Source de rayonnement selon l'une quelconque des revendications 1 à 5, **caractérisée** en ce que des moyens (114e) sont prévus dans l'unité d'alimentation, qui permettent d'introduire une fonction de modulation individuelle pour un exemplaire individuel d'une diode laser.

7. Source de rayonnement selon la revendication 6, **caractérisée** en ce qu'il est prévu, pour la fonction de modulation, un générateur de modulation (114) doté d'éléments de réglage (114e) pour des valeurs de la fonction de modulation.

8. Source de rayonnement selon la revendication 6, **caracterisée** en ce qu'il est prévu, pour la fonction de modulation, un générateur de modulation (114) doté d'éléments de réglage (114e) pour des paramètres de la fonction de modulation.

9. Source de rayonnement selon la revendication 6, **caractérisée** en ce que la fonction de modulation est mémorisée dans un calculateur (125) ou un microprocesseur, qui est relié par l'intermédiaire d'un convertisseur numérique-analogique (124) à la source de courant (123) de l'unité d'alimentation.

10. Procédé de détermination de la fonction de modulation pour une source de rayonnement selon l'une quelconque des revendications 1 à 9, **caractérisé** en ce qu'à partir de la fonction de cohérence souhaitée (11), on détermine par transformation de Fourier la fonction spectrale (21) nécessaire à cet effet, et en ce que la fonction de modulation (61, 62) est déterminée à partir de la fonction spectrale (21) et des courbes caractéristiques suivantes de la diode laser, à savoir nombre d'ondes en fonction du courant d'injection (courbe 41) et puissance en fonction du courant d'injection (courbe 31).

Fig. 1

Fig. 2

Fig. 3

Fig. 4

Fig.5

Fig.6

<u>Fig.7a</u>

k

Zeit ⟶

<u>Fig.7b</u>

k

Zeit ⟶

<u>Fig.8</u>

Diode 1    Diode 2    Diode 3

81    82    83

Intensität

k ⟶

Fig. 9

Diode 3

Diode 2

Diode 1

Wellenzahl k ⟶

Zeit ⟶

Fig. 10

Diode 3

Diode 2

Diode 1

Wellenzahl k ⟶

Zeit ⟶

Fig. 11

Blocks: TEMPERATUR-REGELEINRICHTUNG (112e, 112) → LASERDIODE (111); STROMQUELLE (113); MODULATIONS-GENERATOR (114, 114e)

Fig. 12

Blocks: TEMPERATUR-REGELEINRICHTUNG (122, 122v) → LASERDIODE (111); STROMQUELLE (123, 123v); D-A-WANDLER (124); RECHNER (125)